Europäisches Patentamt

European Patent Office

Office européen des brevets

(11) Publication number: **0 315 424**
**A2**

# EUROPEAN PATENT APPLICATION

(21) Application number: 88310294.9

(22) Date of filing: 02.11.88

(51) Int. Cl.⁴: **H 01 L 29/78**

(30) Priority: 05.11.87 GB 8725943

(43) Date of publication of application:
10.05.89 Bulletin 89/19

(84) Designated Contracting States: FR SE

(71) Applicant: MARCONI ELECTRONIC DEVICES LIMITED
Doddington Road
Lincoln LN6 3LF (GB)

(72) Inventor: Kerr, John Anthony
21 Malham Drive
Lakelands Lincoln LN6 0X2 (GB)

(74) Representative: Hoste, Colin Francis
The General Electric Company p.l.c. Central Patent
Department (Wembley Office) Hirst Research Centre
East Lane
Wembley Middlesex, HA9 7PP (GB)

(54) Field effect transistor arrangement.

(57) A field effect transistor suitable for analogue operation is formed as an island of epitaxial silicon on an insulating substrate. The silicon region underlying the f.e.t. channel region is electrically connected to the source region so as to stabilise its potential. By preventing the potential of the silicon region under the gate from floating an improved turn-on transfer characteristic is obtained, having a smoother and more predictable profile.

Fig.1.

## Description

### Field Effect Transistor Arrangement

This invention relates to field effect transistors and is specifically concerned with such a transistor arrangement formed in an island of silicon which is supported by an inert electrically insulating substrate such as sapphire. It is known that the packing density of field effect transistor devices can be increased by utilising a substrate such as sapphire on which to deposit epitaxial silicon. The silicon so deposited forms a crystalline structure in which a transistor action is possible, and the electrically insulating substrate which supports a large mosaic of transistors enables the individual transistors to be positioned very closely adjacent to each other without giving rise to any electrical short circuit or undesired interaction

Such transistors have been commonly used as part of digital circuits but difficulties arise when they form part of analogue circuits, that is to say circuits in which the amplitude of a signal is of particular importance in contrast to the case in digital systems in which it is merely the presence or absence of a signal which is of significance.

When such transistors are used to handle analogue signals, it is found that the transistor transfer characteristic generally does not exhibit a smooth profile but instead exhibits undesirable kinks. This invention seeks to provide an improved field effect transistor in which this disadvantage is reduced so as to make it suitable for use as part of an analogue circuit.

According to this invention a field effect transistor arrangement includes an island of epitaxial silicon formed to an electrically insulating substrate, a transistor having an n-type drain and n-type source, with the source being provided with adjacent p-type regions at the edges of the island adjacent to a gate electrode which controls the conductivity of a channel region linking the source and drain; and an electrically conductive layer overlying the source and said p-type regions so as to be in contact therewith and acting to electrically connect the source to that region of the epitaxial silicon lying under the gate electrode.

The electrically conductive layer effectively shorts the source to the p=type regions which therefore strap the substrate to the source potential of the silicon. This has the effect of removing the kinks from the output and transfer characteristics of n-channel transistors. It is therefore necessary that the surface area of the p-type regions be sufficiently large as to permit the ready contact therewith of the electrically conductive layer, and preferably the p-type layers extend over the full width of the source of the field effect transistor. Although the p-type regions preferably have an appreciable surface area at the top surface of the island of epitaxial silicon, this is not strictly necessary and it may be sufficient to simply form a p-type region in a side wall of the island.

With analogue field effect transistors, it is customary to fabricate the device as a linear structure having a long narrow gate electrode separating equally long sources and drain regions. In order to ensure that the source is effectively earthed to the substrate along its entire length, preferably p-type regions are formed in the source at intervals along its length. Although the presence of these p-type regions serves to significantly increase the on resistance of the transistor, this disadvantage is more than offset by the improvement in the turn-on characteristics of the transistor.

The invention is further described by way of example with reference to the accompanying drawings in which

Figures 1 to 5 show successive stages in the manufacture of field effect transistors in accordance with the invention, and

Figure 6 shows a modified transistor having a long narrow gate region.

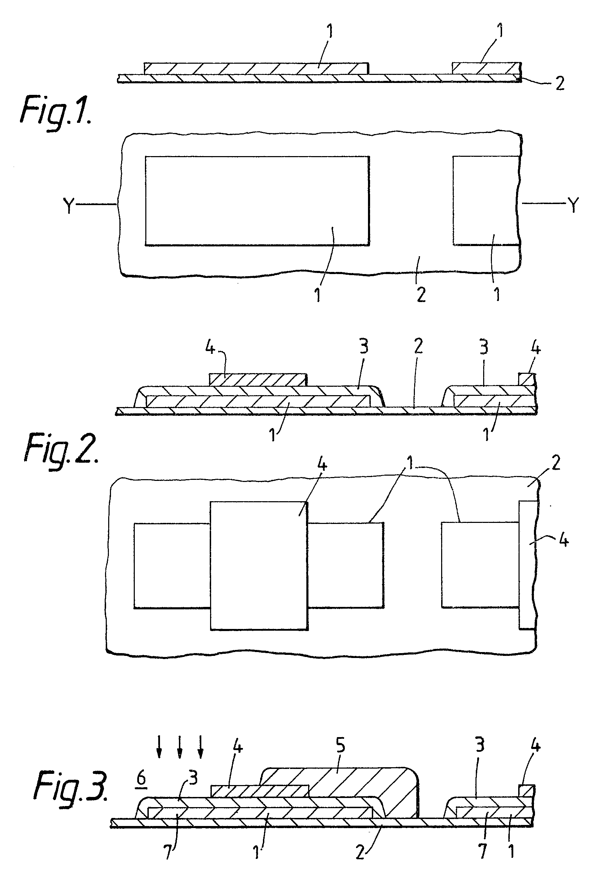

The field effect transistors are formed on an island of epitaxial silicon deposited onto an insulating substrate. In practice a wafer of sapphire is used as the substrate as it has a crystalline structure which is compatible with that of silicon. A coating of silicon is formed on the upper surface of the sapphire by vapour deposition, and as the thickness of the coating increases during deposition, the structure becomes more crystalline. When deposited, the silicon has a resistivity of greater than 100 cm and is slightly p-type. Areas of the layer of the epitaxial silicon are removed by a conventional mask and etch process to leave a large number of small separate islands 1 of the silicon on the surface of the sapphire substrate 2 as shown in Figure 1, the upper drawing of which is a sectional view on the line XY of the lower drawing.

The silicon islands 1 are coated with an electrically insulating thermally grown oxide layer 3, and a gate electrode 4 is then deposited over the oxide, the gate electrode being a highly doped $n^+$ polysilicon which is conductive (Figure 2).

Subsequently a thick layer of resist 5 is laid down over the sapphire substrate, with windows 6 being formed in the resist 5 (Figure 3) so that the windows overlie those portions 7 of the silicon island in which the source region will be formed. The source regions 7 are produced by means of a boron implant (represented by the arrows), through the oxide 3, so that the source region is at this stage $p^+$.

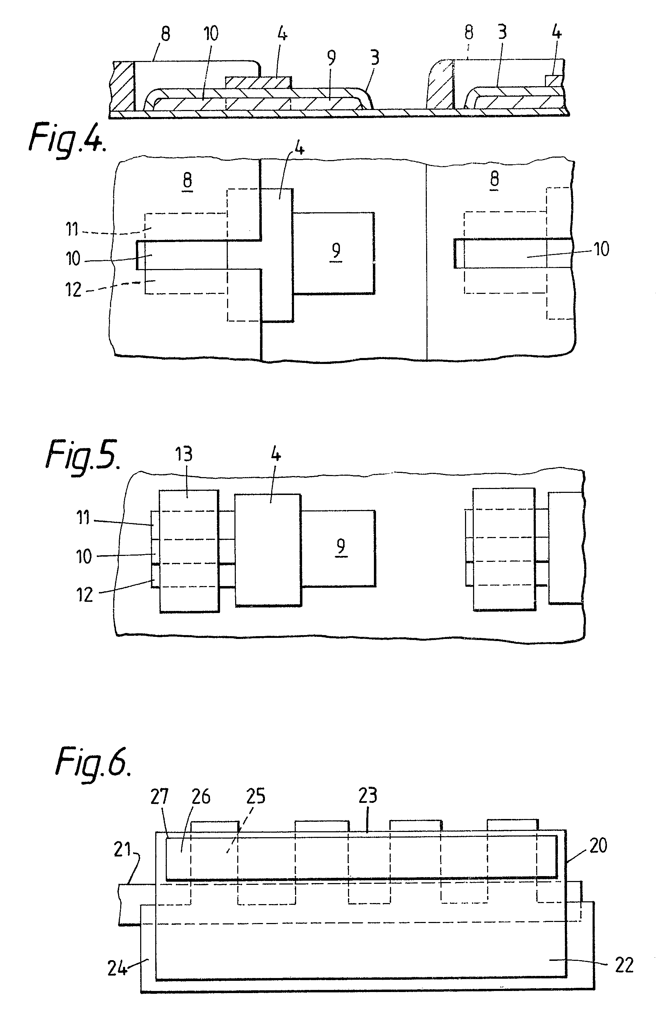

The resist 5 is then removed and a new pattern of resist 8 is laid down as shown in Figure 4. This resist 8 has windows which expose the regions 9 at which the drain is to be formed, and also a region 10 at which the source is to be formed. The resist 8 overlies the regions 11 and 12 which are to remain $p^+$. Phosphorous ($n^+$) is implanted through the windows in the resist 8, and through the oxide 3 to produce the source and drain.

Thus the source 10 and the drain 9 are $n^+$ and the relatively small region of the source 10 has a $p^+$ region 11, 12 on each side of it as shown in Figure 4. The resist 8 is removed, and a window 13 is opened in the oxide 3 in which an electrically conductive metal link is deposited to electrically connect the three regions 10, 11, 12 as shown in Figure 5.

The effect of the $p^+$ regions 11 and 12 is twofold. They act as a channel stop as the $p^+$ diffuses slightly under the gate. As the gate electrode is in close proximity to the side walls of that region of the silicon island lying between the source and drain, the gate electrode has a tendency to cause premature current conduction (turn-on), and these $p^+$ regions prevent a conductive channel being formed at the vicinity of the side walls.

The second effect of the regions 11 and 12 is to hold the body of the silicon at the source potential, (ie to earth it) as the top contact electrically connects the source 10 to the regions 11 and 12. Thus the source 10 is connected electrically to the bulk of the silicon lying under the gate electrode. This prevents the potential of the substrate floating, and avoids the formation of a kink in the output characteristics of the transistor. This aspect is of particular importance for analogue transistors, in which the channel current is desired to be proportional to the potential applied to the gate electrode.

In the structure shown in Figures 1 to 5 it is sufficient for each source region 10 to be provided with just a pair of $p^+$ regions 11 and 12 in order to hold the source sufficiently well at the potential of the body of the silicon underlying the central channel region. This is so as the source and drain regions are relatively small and compact. However in certain kinds of field effect transistors which are used for analogue purposes it may be necessary for the transistor to be capable of conducting a relatively large current between the source and the drain, and this property is achieved by the provision of relatively long source and drain regions which are spaced apart by an equally long but thin channel region. In order to enhance the transfer characteristics of the field effect transistor it is highly desirable to prevent potential variations occurring along the length of the source region itself. In accordance with the invention this is achieved by providing additional $p^+$ regions at intervals along the length of the source.

Such a field effect transistor is illustrated in Figure 6 in which the boundary of an individual island of silicon is represented by the line 20. The gate electrode 21 divides the island into two regions, region 22 of which constitutes the drain and the region 23 of which includes the source. Initially the region 23 is fabricated in a manner which renders it $p^+$ as was the case with the previous arrangement. Subsequently a mask having an aperture following the line 24 is laid over the field effect transistor at n-type impurity implanted or diffused into the device. Thus the drain region 22 is formed during this step at the same time as the individual segments 25 of the source. Individual regions of p-type silicon 26 remain so as to alternate with the source regions 25.

In this way a significant number of individual small regions of $p^+$ material can be distributed regularly along the length of an elongate source region so as to hold the potential of the substrate of the silicon material which underlies the channel region at substantially the potential of the source. In this instance a gate electrode 21 is formed prior to the formation of the source and drain regions so that they are automatically aligned therewith as the gate electrode 21 in combination with the mask 24 serves to define these regions. An elongate electrode 27 is finally formed so as to electrically interconnect the individual source regions and the $p^+$ regions together in a manner which is analogous to that described previously with reference to Figure 5.

## Claims

1. A field effect transistor arrangement including an island of epitaxial silicon formed on an electrically insulating substrate, a transistor having an n-type drain and n-type source, with the source being provided with adjacent p-type regions at the edges of the island adjacent to a gate electrode which controls the conductivity of a channel region linking the source and drain; and an electrically conductive layer overlying the source and said p-type regions so as to be in contact therewith and acting to electrically connect the source to that region of the epitaxial silicon lying under the gate electrode.

2. A transistor arrangement as claimed in Claim 1 and wherein the insulating substrate is formed of sapphire.

3. A transistor arrangement as claimed in Claim 1 or 2 and wherein a plurality of islands are present on a common electrically insulating substrate, each island of which is provided with a field effect transistor.

4. A transistor arrangement as claimed in Claim 1, 2 or 3 and wherein a single n-type source region is provided in each transistor.

5. A transistor arrangement as claimed in Claim 1, 2 or 3 and wherein the drain and gate electrodes of each transistor are relatively long and narrow, and the source is in the form of a plurality of discrete regions separated by p-type regions, with the source regions being electrically connected to the p-type regions.

Fig.1.

Fig.2.

Fig.3.

*Fig.4.*

*Fig.5.*

*Fig.6.*